# EUROPÄISCHE PATENTSCHRIFT

(11) **EP 1 332 522 B1**
(45) Veröffentlichungstag und Bekanntmachung des Hinweises auf die Patenterteilung: **17.10.2007**
(21) Anmeldenummer: 01993948.7
(22) Anmeldetag: 07.11.2001
(51) Int. Cl.: H01L 41/083

(54) **PIEZOAKTOR**
PIEZO-ACTUATOR
ACTIONNEUR PIEZO-ELECTRIQUE

(30) Priorität: 08.11.2000 DE 10055241
(43) Veröffentlichungstag der Anmeldung: 06.08.2003
(73) Patentinhaber: EPCOS AG, 81669 München (DE)
(72) Erfinder: FLORIAN, Heinz, A-8524 Bad Gams (AT)
(74) Vertreter: Epping - Hermann - Fischer
(86) Internationale Anmeldenummer: PCT/DE2001/004180
(87) Internationale Veröffentlichungsnummer: WO 2002/039510

(56) Entgegenhaltungen:
- DE-A- 4 201 937
- DE-A- 19 740 570
- PATENT ABSTRACTS OF JAPAN vol. 1995, no. 07, 31. August 1995 (1995-08-31) & JP 07 106653 A (HITACHI METALS LTD), 21. April 1995 (1995-04-21) -& JP 07 106653 A (HITACHI METALS LTD) 21. April 1995 (1995-04-21)
- PATENT ABSTRACTS OF JAPAN vol. 014, no. 550 (E-1009), 6. Dezember 1990 (1990-12-06) & JP 02 237084 A (HITACHI METALS LTD), 19. September 1990 (1990-09-19) -& JP 02 237084 A (HITACHI METALS LTD) 19. September 1990 (1990-09-19)

## Beschreibung

Die Erfindung betrifft einen Piezoaktor mit einem Stapel von übereinander liegenden piezoelektrischen Schichten, die jeweils durch eine Elektrodenschicht voneinander getrennt sind.

Es sind Piezoaktoren der eingangs genannten Art bekannt, bei denen die Elektrodenschichten als kammartig ineinander greifende Strukturen ausgebildet sind. Die jeweils zu einem Kamm gehörenden Elektrodenschichten sind durch am Rand des Stapels angeordnete, aus einer Silber-Einbrennpaste hergestellte Kontaktschichten elektrisch kontaktiert. In einem Mittelbereich des Stapels, in dem die zu verschiedenen Kämmen gehörende Elektrodenschichten einander überlappen, dehnt sich der Aktor in Längsrichtung des Stapels bei Anlegen einer elektrischen Spannung aus. Im Gegensatz dazu findet in den Randbereichen des Stapels eine solche Ausdehnung nicht statt. Daher resultieren in den inaktiven Randbereichen des Stapels Zugspannungen.

Die Belastbarkeit der üblicherweise als piezoelektrisches Material verwendeten Keramik auf Zug ist gering. Die an der Grenze zwischen Mittel- und Randbereich entstehenden Risse können sich an die Keramikoberfläche fortpflanzen und gefährden dadurch die Funktion des Bauelements. Die Elektrodenschichten in den Aktoren müssen nämlich zur Spannungsversorgung an den Seitenflächen leitend miteinander verbunden beziehungsweise kontaktiert werden. Eine Unterbrechung dieser Kontaktierung gefährdet die Spannungsversorgung der Elektrodenschichten. Dieses Problem wird durch hohe Ladungsströme im Aktorbetrieb noch weiter verschärft, da diese an einer beschädigten Kontaktstelle zu einer ohmschen Erwärmung der Stelle und damit zu einer thermischen Zerstörung der noch bestehenden leitenden Restverbindung führen kann.

Um die Entstehung solcher Risse im Randbereich des Aktors zu verhindern, kann der Piezoaktor moderat auf Druck belastet werden, was bei bekannten Piezoaktoren durch Einspannen des Stapels in eine Rohrfeder geschieht, die die Grund- beziehungsweise die Deckfläche mit uniaxialem Druck von etwa 850 N aufeinander drückt. Aus der Druckschrift JP 02 237 084 A ist ein Piezoaktor mit Verstärkungselementen bekannt, die an Seitenflächen der Innenelektroden angeordnet sind, um Rissbildung vorzubeugen.

Um zudem einen Ausfall von Elektrodenschichten bei Unterbrechung der am Rand des Stapels angeordneten Kontaktschichten zu vermeiden, werden zahlreiche Einzeldrähte in regelmäßigen Abständen an den Aktor angelötet.

Sowohl das Einspannen des Aktors in eine Rohrfeder als auch das Anbringen einer großen Anzahl von Lötstellen auf die Kontaktierungsschicht stellen aufwendige Verfahrensweisen mit entsprechenden wirtschaftlichen Nachteilen des bekannten Piezoaktors dar.

Ziel der vorliegenden Erfindung ist es daher, einen Piezoaktor anzugeben, bei dem die Zugbelastung am Rand des Stapels mit einfachen Mitteln verringert ist.

Dieses Ziel wird erfindungsgemäß durch einen Piezoaktor nach Patentanspruch 1 erreicht. Vorteilhafte Ausgestaltungen der Erfindung sind den weiteren Patentansprüchen zu entnehmen.

Die Erfindung gibt einen Piezoaktor an, der einen Stapel von übereinanderliegenden piezoelektrischen Schichten aufweist. Zwischen diesen piezoelektrischen Schichten sind Elektrodenschichten angeordnet. An zwei gegenüberliegenden Seitenflächen des Stapels ist je eine elektrische Kontaktschicht zur Kontaktierung der Elektrodenschichten angeordnet. Auf jeder Kontaktschicht ist ein Stabilisierungselement flächig befestigt, das die Höhe des Stapels an den Seitenflächen so fixiert, daß sich diese Höhe bei Anlegen einer Betriebsspannung an die Elektrodenschichten nicht ändert. Die Kontaktschicht umfasst eine Silber-Einbrennpaste.

Da sich bei einer flächigen Befestigung des Stabilisierungselements auf einer Seitenfläche des Stapels die auftretenden Zugkräfte dabei auf die ganze Seitenfläche des Stapels verteilen, wird mit einer minimalen Befestigungskraft eine maximale Stabilität erreicht. Somit hat dieser Piezoaktor den Vorteil, daß mittels der Stabilisierungselemente die elektrischen Kontaktschichten wirksam vor Rissen aufgrund der Zugbelastung der piezoelektrischen Schichten geschützt werden können. Dadurch wird die Zuverlässigkeit der elektrischen Kontaktierung der Elektrodenschichten verbessert.

Der erfindungsgemäße Piezoaktor hat den Vorteil, daß die beim Betrieb des Aktors an der Seitenfläche des Stapels auftretenden Zugkräfte durch das Stabilisierungselement aufgenommen werden können. Dadurch kann auf eine aufwendige Konstruktion gemäß der bekannten Rohrfeder verzichtet werden.

Das Stabilisierungselement ist ferner an den Seitenflächen des Stapels, also genau an dem kritischen Punkt befestigt, wo das Aufreißen der piezoelektrischen Schichten den meisten Schaden anrichten kann. Es sorgt darüber hinaus für einen kompakten Aufbau des erfindungsgemäßen Piezoaktors.

Die Stabilisierung des Aktors kann noch verbessert werden, indem vorzugsweise auf zwei gegenüberliegenden Seitenflächen des Stapels Stabilisierungselemente angeordnet sind.

In einer vorteilhaften Ausführungsform des Piezoaktors ist das Stabilisierungselement als Blech ausgeführt, das sich über die gesamte Höhe des Stapels erstreckt. Die Ausführung des Stabilisierungselementes als Blech erlaubt eine sehr einfache und materialsparende Möglichkeit, dessen Stabilität festzulegen und somit an unterschiedliche Aktorausführungen anzupassen. Die Anpassung kann beispielsweise über das für das Blech gewählte Material beziehungsweise über die Dicke des verwendeten Blechs erfolgen. Somit kann die mechanische Stabilität des Stabilisierungselementes bei minimalem Materialeinsatz optimal gestaltet werden. Dabei können insbesondere vorteilhaft Metallbleche, wie beispielsweise Kupferbleche oder auch Aluminiumbleche verwendet werden.

Es ist vorteilhaft, die Stabilisierungselemente selbst zur Kontaktierung der Elektrodenschichten zu verwenden, indem die Stabilisierungselemente und deren Befestigung auf den Kontaktschichten elektrisch leitend ausgeführt sind, und indem die Stabilisierungselemente mit elektrischen Außenanschlüssen kontaktiert sind.

Die Stabilisierungselemente weisen eine ausreichende mechanische Stabilität aus und werden daher im Unterschied zu den lediglich der elektrischen Kontaktierung dienenden Kontaktschichten durch die mechanischen Zugspannungen nicht zerstört. Sie ermöglichen darüber hinaus das Anbringen eines zuverlässigen Kontaktelements, beispielsweise das Anlöten einer flexiblen Litze, wobei die Lötstelle so massiv gestaltet werden kann, daß sie auch bei Auftreten von äußeren Vibrationen nicht so leicht beschädigt wird.

Desweiteren kann als Stabilisierungselement ein mit Löchern versehenes metallisches Blech verwendet werden. Ein solches Blech bietet den Vorteil eines geringeren Materialeinsatzes beziehungsweise weist weniger Gewicht auf als ein massives Blech. Aufgrund der Löcher in dem Blech ist ein solches Blech auch leichter durch Löten zu befestigen als ein massives Blech.

Im folgenden wird die Erfindung anhand eines Ausführungsbeispiels und der dazugehörigen Figur näher erläutert.

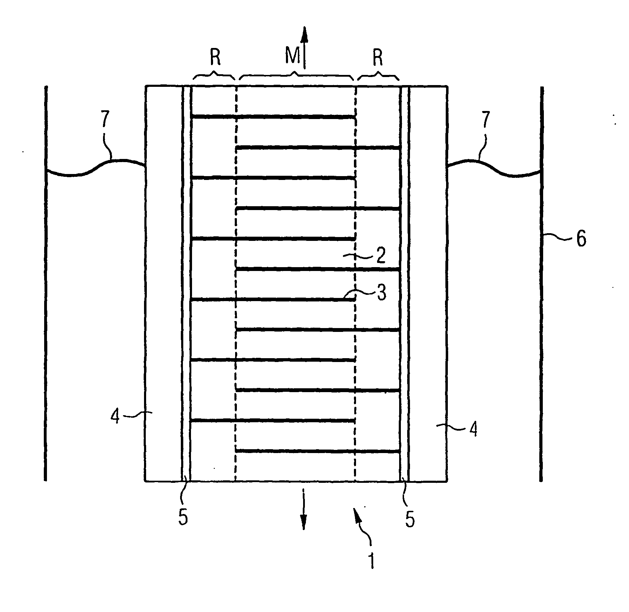

Die Figur zeigt beispielhaft einen erfindungsgemäßen Piezoaktor im schematischen Querschnitt.

Die Figur zeigt einen Piezoaktor mit einem Stapel 1 von übereinanderliegenden piezoelektrischen Schichten 2. Die piezoelektrischen Schichten 2 bestehen aus einer Piezokeramik, welche 67 Gew.-% Pb₃O₄, zirka 1 Gew.-% Nd₂O₃, 21 Gew.-% ZrO₂ und zirka 11 Gew.-% TiO₂ aufweist. Die Erfindung ist jedoch nicht auf eine solche Piezokeramik beschränkt, sondern kann mit sämtlichen piezoelektrischen Schichten 2 verwirklicht werden, die geeignete piezoelektrischen Eigenschaften aufweisen.

Der Stapel 1 weist Elektrodenschichten 3 auf, die kammartig ineinander greifen, wodurch sich die piezoelektrischen Effekte vieler piezoelektrischer Schichten 2 aufsummieren. Die Elektrodenschichten 3 bestehen aus einer Mischung von Silber und Palladium im Gewichtsverhältnis zwischen 90/10 und 70/30. Der Stapel 1 ist durch gemeinsames Sintern von Elektrodenschichten 3 und piezoelektrischen Schichten 2 hergestellt, weswegen als Elektrodenschichten 3 alle bei Sinterbedingungen stabilen Metalle beziehungsweise Metallegierungen geeignet sind. So kommen insbesondere auch Elektrodenschichten 3 aus Kupfer in Betracht. Die jeweils zu einem Kamm gehörenden Elektrodenschichten 3 sind mittels einer an der Außenseite des Stapels 1 angebrachten Kontaktschicht 5 elektrisch leitend miteinander verbunden. Diese Kontaktschicht 5 kann beispielsweise aus einer Silber-Einbrennpaste hergestellt sein.

Der Stapel 1 hat die Form eines Quaders mit einer Grundfläche von 7 x 7 mm. Er weist eine Höhe von 60 mm auf.

Bei Anlegen einer geeigneten elektrischen Spannung zwischen den Kontaktschichten 5 dehnt sich der Stapel 1 in die mit den beiden Pfeilen bezeichnete Richtung aus, und zwar vorzugsweise in einem Mittelbereich M, in dem die Elektrodenschichten 3 einander überlappen. In einem Randbereich R, in dem die Elektrodenschichten 3 einander nicht überlappen, dehnt sich der Stapel 1 dementsprechend wesentlich weniger aus, wodurch es zu Zugbelastungen in der kritischen Übergangszone zwischen dem Mittelbereich M und dem Randbereich R kommt, wobei diese Zugbelastungen der piezoelektrischen Schicht 2 bis auf den Rand des Stapels 1 durchgreifen können. Um das Reißen der piezoelektrischen Schichten 2 am Rand des Stapels 1 zu verhindern, ist dort jeweils ein Stabilisierungselement 4 befestigt.

Als Stabilisierungselement 4 kann beispielsweise ein Aluminiumblech mit einer Dicke von 2 mm verwendet werden. Das Stabilisierungselement 4 erstreckt sich über die gesamte Höhe des Stapels 1 und ist somit zusammen mit einer geeigneten Befestigung, beispielsweise Löten, dazu geeignet, die Höhe des Stapels 1 so zu fixieren, daß sie sich auch beim Betrieb des Piezoaktors nicht mehr verändert. Dadurch kann das Auftreten von Rissen im Randbereich R der piezoelektrischen Schichten 2 wirksam verhindert werden.

Es kann darüber hinaus das Stabilisierungselement 4 in Form eines metallisch leitenden Blechs ausgeführt sein, wodurch es auch zur elektrischen Kontaktierung der Elektrodenschichten 3 verwendet werden kann. Dies geschieht beispielsweise, indem das Stabilisierungselement 4 mittels einer Litze 7 aus Kupferdraht mit einem festen Außenanschluß 6 elektrisch leitend verbunden ist.

Die vorliegende Erfindung beschränkt sich nicht auf das dargestellte Ausführungsbeispiel, sondern wird in ihrer allgemeinsten Form durch Patentanspruch 1 definiert.

## Patentansprüche

1. Piezoaktor mit
- einem Stapel (1) mit übereinanderliegenden piezoelektrischen Schichten (2) und dazwischenliegenden Elektrodenschichten (3),
- bei dem an einer Seitenfläche des Stapels (1) ein Stabilisierungselement (4) befestigt ist, das die Höhe des Stapels (1) an der Seitenfläche so fixiert, daß sich diese Höhe bei Anlegen einer Betriebsspannung an die Elektrodenschichten (3) nicht ändert.

2. Piezoaktor nach Anspruch 1,
bei dem das Stabilisierungselement (4) ein Blech ist, das sich über die gesamte Höhe des Stapels (1) erstreckt.

3. Piezoaktor nach Anspruch 2,
bei dem das Stabilisierungselement (4) flächig befestigt ist.

4. Piezoaktor nach Anspruch 3,
bei dem das Stabilisierungselement (4) durch Löten, Kleben oder Schweißen befestigt ist.

5. Piezoaktor nach Anspruch 1 bis 3,
bei dem an zwei gegenüberliegenden Seitenflächen des Stapels (1) je eine elektrische Kontaktschicht (5) zur Kontaktierung der Elektrodenschichten (3) angeordnet ist, und bei dem auf jeder Kontaktschicht (5) ein Stabilisierungselement (4) flächig befestigt ist.

6. Piezoaktor nach Anspruch 5,
bei dem die Stabilisierungselemente (4) und deren Befestigung auf den Kontaktschichten (5) elektrisch leitend sind und bei dem die Stabilisierungselemente (4) mit elektrischen Außenanschlüssen (6) kontaktiert sind.

7. Piezoaktor nach Anspruch 1 bis 6,
bei dem das Stabilisierungselement (4) ein mit Löchern versehenes metallisches Blech ist.

8. Piezoaktor nach Anspruch 1 bis 7,
bei dem an zwei gegenüberliegenden Seitenflächen des Stapels (1) jeweils ein Stabilisierungselement (4) befestigt ist.

## Claims

1. Piezoactuator, comprising
- a stack (1) with piezoelectric layers (2) that lie on top of one another and electrode layers (3) lying between them,
- whereby a stabilisation element (4) is attached to a side surface of the stack (1), thereby fixing the height of the stack (1) at the side surface such that this height does not change when an operating voltage is applied to the electrode layers.

2. Piezoactuator according to claim 1, wherein the stabilisation element (4) is a sheet of metal that extends over the entire height of the stack (1).

3. Piezoactuator according to claim 2, wherein the stabilisation element (4) is attached to the side surface of the stack (1) in a laminar manner.

4. Piezoactuator according to claim 3, wherein the stabilisation element (4) is attached by means of soldering, gluing and welding.

5. Piezoactuator according to claims 1 to 3, wherein an electrical contact layer (5) for contacting the electrode layers (3) is arranged on each of two opposite side surfaces of the stack (1) and wherein a stabilisation element (4) is attached to each contact layer (5) in a laminar manner.

6. Piezoactuator according to claim 5, wherein the stabilisation elements (4) and their respective attachment to the contact layers (5) are electrically conductive and wherein the stabilisation elements (3) are contacted with outer electrical contacts (6).

7. Piezoactuator according to claims 1 to 6, wherein the stabilisation element (4) is metallic sheet provided with holes.

8. Piezoactuator according to claims 1 to 7, wherein a stabilisation element (4) is attached to each of two opposite side surfaces of the stack (1).

## Revendications

1. Actionneur piézoélectrique
- qui est constitué d'une pile (1) qui comporte des couches piézoélectriques superposées (2) entre lesquelles sont disposées des couches d'électrode (3), et
- dans lequel, sur une surface latérale de la pile (1) est fixé un élément de stabilisation (4) qui définit la hauteur de la pile (1) sur la face latérale de sorte que cette hauteur ne varie pas lorsque l'on applique une tension de fonctionnement aux couches d'électrode (3).

2. Actionneur piézoélectrique selon la revendication 1, dans lequel l'élément de stabilisation (4) est une tôle qui s'étend sur toute la hauteur de la pile (1).

3. Actionneur piézoélectrique selon la revendication 2, dans lequel l'élément de stabilisation (4) est fixé à plat.

4. Actionneur piézoélectrique selon la revendication 3, dans lequel l'élément de stabilisation (4) est fixé par brasage, collage ou soudage.

5. Actionneur piézoélectrique selon les revendications 1 à 3, dans lequel sur deux surfaces latérales opposées de la pile (1) sont disposés respectivement une couche de contact (5) électrique pour la mise en contact des couches d'électrode (3) et dans lequel un élément de stabilisation (4) est fixé à plat sur la couche de contact respective (5).

6. Actionneur piézoélectrique selon la revendication 5, dans lequel les éléments de stabilisation (4) et leur fixation aux couches de contact (5) sont réalisés de façon à être électriquement conducteurs et dans lequel les éléments de stabilisation (4) sont en contact avec des bornes électriques extérieures (6).

7. Actionneur piézoélectrique selon les revendications 1 à 6, dans lequel les éléments de stabilisation (4) sont des tôles métalliques dotées de trous.

8. Actionneur piézoélectrique selon les revendications 1 à 7, dans lequel des éléments de stabilisation (4) sont fixés respectivement à deux faces latérales opposées de la pile (1).
